## Europäisches Patentamt
## European Patent Office
## Office européen des brevets

(11) Veröffentlichungsnummer: **0 046 499**
**B1**

(12) # EUROPÄISCHE PATENTSCHRIFT

(45) Veröffentlichungstag der Patentschrift:
**10.08.83**

(51) Int. Cl.³: **G 06 F 11/26,** G 11 C 19/00

(21) Anmeldenummer: **81105492.3**

(22) Anmeldetag: **14.07.81**

(54) **Schieberegister für Prüf- und Test-Zwecke.**

(30) Priorität: **07.08.80 DE 3029883**

(43) Veröffentlichungstag der Anmeldung:
**03.03.82 Patentblatt 82/9**

(45) Bekanntmachung des Hinweises auf die Patenterteilung:
**10.08.83 Patentblatt 83/32**

(84) Benannte Vertragsstaaten:
**DE FR GB**

(56) Entgegenhaltungen:
**US-A-3 815 025**

**IBM TECHNICAL DISCLOSURE BULLETIN, Band 19, Nr.
.8, Januar 1977, Seiten 2951–2952 New York, U.S.A. R.C.
FLAKER et al.: "Power minimization of LSSD SRLS"**

(73) Patentinhaber: **IBM DEUTSCHLAND GMBH,
Pascalstrasse 100, D-7000 Stuttgart 80 (DE)**

(84) Benannte Vertragsstaaten: **DE**

(73) Patentinhaber: **International Business Machines
Corporation, Old Orchard Road, Armonk, N.Y. 10504 (US)**

(84) Benannte Vertragsstaaten: **FR GB**

(72) Erfinder: **Blum, Arnold, Finkenweg 16, D-7261 Gechingen
(DE)**

(74) Vertreter: **Rudolph, Wolfgang, Schönaicher Strasse 220,
D-7030 Böblingen (DE)**

## Schieberegister für Prüf- und Test-Zwecke

Die Erfindung betrifft ein Schieberegister nach dem Oberbegriff des Patentanspruchs 1.

Mit fortschreitender Integrierung bis zur hochgradigen Integrationstechnik (LSI) wurde und wird die direkte Zugänglichkeit zu einer Schaltungsgruppe in einer physikalischen Einheit (z.B. einem Chip, einem Modul) immer stärker eingeschränkt. Diese Sachlage ist sowohl auf die stark ansteigende Anzahl von Schaltungen innerhalb der LSI-Einheit als auch auf die mikroskopischen Abmessungen zurückzuführen, die diese Schaltungen heute haben. Das Ausprüfen dieser Schaltungen ist damit zu einem Hauptproblem bei der Herstellung von hochintegrierten Schaltungen geworden.

Das Ausprüfen einer LSI-Einheit wird nämlich dadurch erschwert, dass unzugängliche Speicherelemente und Verriegelungsschaltungen vorhanden sind, die regulär in die logischen Kombinationsnetzwerke eingebettet sind. Ohne aber die logischen Zustände dieser eingebetteten Verriegelungen sicher prüfen und untersuchen zu können, kann man auch die zugehörigen logischen Netzwerke nicht prüfen. Trotzdem kann man aber sowohl bei der Herstellung als auch beim Betrieb nicht auf eine zuverlässige und sorgfältige Prüfung aller LSI-Bauelemente bzw. -Einheiten verzichten.

Einige nachfolgend diskutierte US-Patentschriften aus der letzten Zeit sehen zwar Systemkonstruktionsverfahren und -disziplinen vor, die die oben gestellten Fragen beantworten sollen. Sie alle laufen unter dem Titel «LSSD» (Levelempfindliche Abfragekonstruktion). Eine Gemeinsamkeit dieser bekannten Lösungen besteht darin, dass eine eingebaute Schaltung für jede LSI-Einheit vorgeschrieben wird, durch die der ganze logische Zustand der Einheit in der Prüfung explizit festgelegt und/oder durch Anwendung bestimmter Eingabe- und Ausgabeverfahren an einer begrenzten Anzahl von E/A-Anschlüssen untersucht werden kann. Diese Forderungen lassen sich dadurch verwirklichen, dass man jeder Verriegelung des logischen Systems in der Einheit eine Schieberegistermöglichkeit gibt und daraufhin diese Schieberegisterverriegelungen (SRL) zu einem oder mehreren Schieberegister-Datenkanälen zusammenschliesst bzw. organisiert, deren Anschlusstufen von aussen zugänglich sind.

Detaillierte Operationen mit dieser SRL-Einrichtung für verschiedene Prüfgesichtspunkte werden in der US-PS 3 761 695 und in den Fig. 7 bis 9 der US-PS 3 784 907 angegeben.

Die wichtigsten Punkte lassen sich wie folgt zusammenfassen: Im Prüfbetrieb werden bestimmte gewünschte logische Prüfmuster seriell eingegeben und an die entsprechenden Verriegelungsstellen verschoben, wenn die Einheit im Schiebebetrieb betrieben wird, d.h. durch Zurückhaltung des System-Taktes und Einschaltung der Schiebetaktimpulse an der Einheit. Wenn dies geschieht, liefern die Verriegelungszustände der einzelnen Schaltungen die gewünschten Impulse zum Prüfen der zugehörigen logischen Netzwerke. Jetzt werden die Prüfmuster durch die Netzwerke weitergeleitet, durch Ausführung eines oder mehrerer Schritte des Funktionsbetriebes, d.h. durch eine gewöhnliche System-Takterregung. Die Antwortmuster der logischen Netzwerke auf die angelegten Impulse werden jetzt durch die Systemverriegelungen auf bekannte Weise abhängig von bestimmten Zuständen in der maschinellen Konstruktion festgehalten, die oft die ursprünglich eingegebenen Prüfmuster ersetzen. Zur Untersuchung kehrt man in den Schiebebetrieb zurück und gibt diese Antwortmuster aus. Durch die in der Praxis übliche Benutzung konventioneller Schieberegister für die SRL's erhält man die Möglichkeit auf Kosten der Hardware prüfen und testen zu können, was in den meisten Fällen eine beträchtliche wirtschaftliche Belastung darstellt (die Erfahrung zeigt, dass die Hardware wenigstens 10 bis 35% und mehr teurer werden kann). Dies ist hauptsächlich darauf zurückzuführen, dass jeder Systemverriegelung eine zweite Verriegelung hinzugefügt werden muss, damit sie auf bekannte Weise zu einer arbeitsfähigen S.R.L-Stufe wird.

Konventionelle Schieberegister benutzen deshalb zwei Verriegelungen für jede Schieberegisterstufe. Einschiebe- und Ausschiebeoperationen werden durch paralleles Anlegen einer zweiphasigen Taktfolge vorgenommen.

Das in der US-PS 3 783 254 gezeigte Schieberegister verwendet zwei Gleichstrom-Verriegelungsschaltungen für jede Schieberegisterstufe, Einschiebe- und Ausschiebeoperationen erfolgen durch paralleles Anlegen eines zweiphasigen Taktsystems an eine erste und zweite Verriegelungsschaltung einer jeden Stufe des Schieberegisters.

Um den Aufwand der doppelten Veriegelungsschaltungen zu verringern, wurde durch die DE-OS 2 723 594 ein Schieberegister für Prüf- und Testzwecke bekannt, das bei gleicher Funktion jedoch nur noch halb soviele Verriegelungsschaltungen benötigt. Dies wird dadurch erreicht, dass jedem Schaltkreis oder jeder Schaltkreisgruppe für eine bestimmte logische Funktion oder Speicherfunktion eine Verriegelungsschaltung zugeordnet ist, dass diese Verriegelungsschaltungen gleichzeitig Stufen des Schieberegisters sind, das über seinen Eingang Prüf- bzw. Testinformationen erhält und an seinem Ausgang bestimmte Bitmuster in Abhängigkeit der eingegebenen Prüf- und Testinformationen sowie des Zustands des zu prüfenden integrierten Schaltkreises abgibt, und dass die Verriegelungsschaltungen abwechselnd mit A- und B-Impulsen innerhalb eines einen Testkanal bildenden Schieberegisters in Abhängigkeit einer Schieb-Takt-Leitsteuerung fortgeschaltet werden, wodurch die verschiedenen Verriegelungsschaltkreise zu einer Taktzeit (A oder B) einzeln oder mehrmals aktiv werden. Die Information wird dadurch im Schieberegister komprimiert und auseinandergezogen nach Art eines Akkordeons.

Diese Lösung hat jedoch immer noch einen relativ hohen Anteil an Hilfsschaltkreisen, nämlich mindestens die Hälfte im Verhältnis zu den Hauptschaltkreisen, und darüber hinaus ist eine sehr aufwendige Leitungsführung und Leitungssteuerung erforderlich, die die Integration und Testmöglichkeiten wesentlich einschränken.

Der Erfindung liegt deshalb die Aufgabe zugrunde, ein Schieberegister für Prüf- und Testzwecke auf Speicher- und Logik-Chips zu schaffen, das weniger Hilfsschaltkreise benötigt und ausserdem auch eine einfachere Leitungsführung als die bisher bekannten aufweist.

Die erfindungsgemässe Lösung besteht im Kennzeichen des Patentanspruchs 1.

Ausgestaltungen dieser Lösung sind in den Patentansprüchen 2 bis 4 charakterisiert.

Dadurch, dass die Hilfsverriegelungs-Schaltkreise von den Hauptverriegelungs-Schaltkreisen logisch getrennt worden sind und die Hilfsverriegelungs-Schaltkreise mit mehreren Schiebeeingängen versehen worden sind, ist es möglich, dynamisch den Hauptverriegelungs-Schaltkreisen eines Schieberegisters oder Gruppen von Hauptverriegelungs-Schaltungen eines Schieberegisters nur eine physisch vorhandene Hilfsverriegelungs-Schaltung zum gegebenen Zeitpunkt zuzuordnen. Für jede Hauptverriegelungs-Schaltung gibt es somit gewissermassen je eine imaginäre Hilfsverriegelungs-Schaltung, obwohl tatsächlich für eine Gruppe von Hauptverriegelungs-Schaltungen nur eine Hilfsverriegelungs-Schaltung auf dem Halbleiterchip vorhanden ist. Diese Lösung führt zu einer wesentlichen Verringerung der Hilfsverriegelungs-Schaltungen und auch zu einer Verringerung der Steuerleitungen, so dass auf dem Halbleiterchip Platz eingespart werden kann, der für Speicherschaltkreise oder logische Schaltkreise innerhalb des Systems, das auf dem Halbleiterchip aufgebracht ist, nutzbringend verwendet werden kann. Dies ist insbesondere dann von Vorteil, wenn ein vollständiger Mikroprozessor auf nur einem Chip angeordnet werden soll, da hier der zur Verfügung stehende Platz äusserst beschränkt ist. Die Testfunktionen und -zeiten werden durch dieses Konzept ebenfalls nicht eingeschränkt, so dass die volle Prüf- und Testfähigkeit eines Halbleiterchips erhalten bleibt.

Die Erfindung wird nun anhand von in den Zeichnungen dargestellten Ausführungsbeispielen näher beschrieben.

Es zeigen:

Fig. 1 ein bekanntes Schieberegister
Fig. 2 ein Schieberegister, bei dem Hauptverriegelungs-Schaltungen, die eine Gruppe bilden, nur eine physikalische Hilfsverriegelungs-Schaltung zugeordnet ist und
Fig. 3 und 4 Zeitdiagramme, aus denen die Wirkungsweise des Schieberegisters nach Fig. 2 hervorgeht.

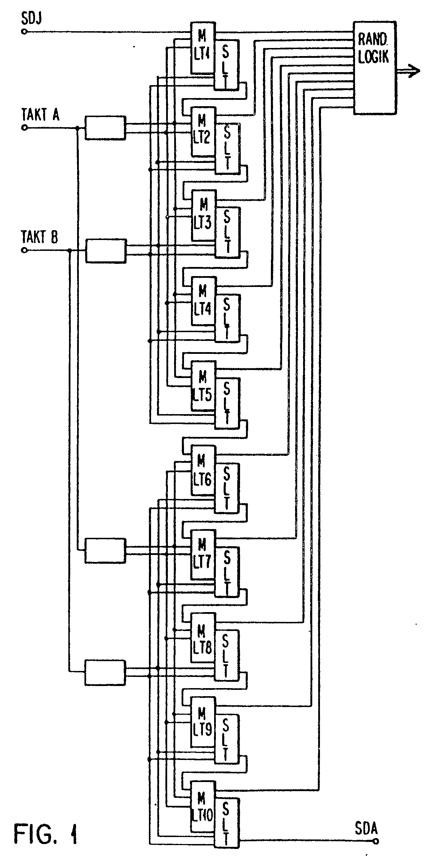

Das in Fig. 1 dargestellte Schieberegister ist ein bekanntes Schieberegister, das zum Testen, Prüfen und sonstigen logischen Operationen dient und für diese Zwecke direkt auf einem logischen Halbleiterchip oder auf einem Speicherchip angeordnet sein kann. Die Stufen dieses Schieberegisters bestehen aus einer Hauptverriegelungs-Schaltung MLT und einer zugeordneten Hilfsverriegelungs-Schaltung SLT. Dadurch ist gewährleistet, dass bei einer Verschiebung keine Daten verlorengehen und eine einwandfreie Testoperation möglich ist.

Beim Herausschieben einer gespeicherten binären Information aus einer Stufe wird die Hilfsverriegelung SLT mittels Takt B mit der Information aus der vorgeschalteten Hauptverriegelung MLT gesetzt, um dann mit dem folgenden Takt A diese Information an die nachgeschaltete Hauptverriegelungs-Schaltung MLT weiterzugeben. Daraus ergibt sich, dass die Hilfsverriegelungs-Schaltung SLT nur ein Mittel zum Herausschieben der Information aus dem Hauptschaltkreis MLT ist. Das Steuern der Hauptverriegelungs-Schaltkreise MLT geschieht mit dem Verschiebetakt A. Die Daten werden auf die Eingangsleitung SDI zum Einschieben in das Schieberegister gegeben und gelangen aus dem Schieberegister auf der Leitung SDA. Die in die Hauptverriegelungs-Schaltungen MLT einer jeden Stufe des Schieberegisters angeschlossene Randomlogik ermöglicht die Auswertung des Speicherzustandes des Schieberegisters und kann z.B. getestet werden.

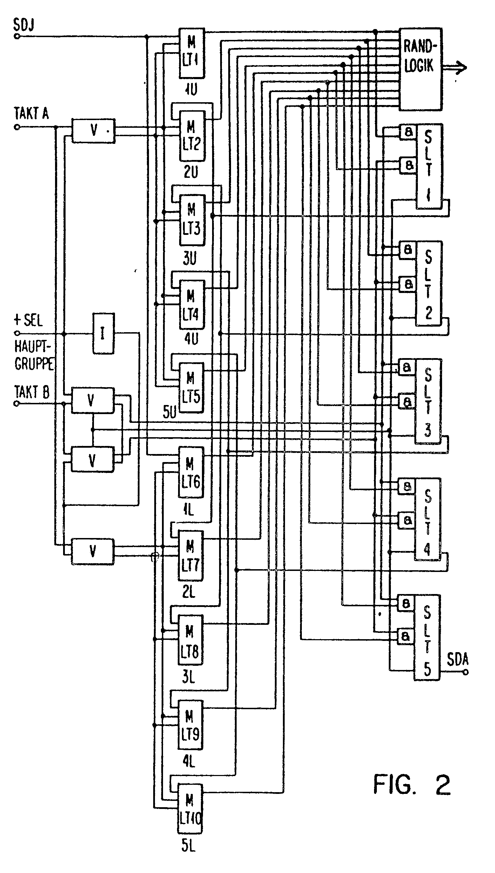

In Fig. 2 ist ein erfindungsgemässes Schieberegister dargestellt, das ebenfalls aus Hauptverriegelungs-Schaltkreisen MLT und Hilfsverriegelungs-Schaltungen SLT besteht. Der Unterschied zu dem in Fig. 1 dargestellten Schieberegister besteht jedoch darin, dass zwischen den Hauptverriegelungs-Schaltungen MLT und den Hilfsverriegelungs-Schaltungen SLT keine feste Zuordnung vorhanden ist, so dass weniger Hilfsverriegelungs-Schaltungen SLT erforderlich sind als Hauptverriegelungs-Schaltkreise MLT, d.h. als Stufen im Schieberegister vorhanden sind. Im vorliegenden Falle sind den zehn Hauptverriegelungs-Schaltungen MLT1 bis MLT10 fünf Hilfsverriegelungs-Schaltungen SLT1 bis SLT5 zugeordnet. Die Hilfsverriegelungs-Schaltkreise SLT1 bis SLT5 sind im vorliegendne Beispiel mit zwei Verschiebedateneingängen ausgestattet. Ausserdem sind jeder Hilfsverriegelungs-Schaltung SLT1 bis SLT5 zwei UND-Schaltungen & vorgeschaltet.

Um nun eine dynamische Zuordnung der fünf Hilfsverriegelungs-Schaltungen SLT1 bis SLT5 zu den zehn Hauptverriegelungs-Schaltungen MLT1 bis MLT10 zu gewährleisten, sind die Hauptverriegelungs-Schaltungen in zwei Gruppen unterteilt. Es soll hier angemerkt werden, dass auch eine andere Anzahl von Hilfsschaltkreisen und eine dementsprechend andere Aufteilung der Gruppen der Hauptverriegelungs-Schaltungen möglich ist.

Damit ist die Gesamtheit der Hauptverriegelungs-Schaltungen MLT1 bis MLT10 in zwei Gruppen L und U zu jeweils fünf Hauptverriegelungs-Schaltungen aufgeteilt. Aus jeder Gruppe wird jeweils eine Hauptverriegelungs-Schaltung den Schiebe-Dateneingängen einer jeden Hilfsverriegelungs-Schaltung zugeordnet. Die Zuordnung erfolgt durch das Signal +SEL-Hauptgruppe, welches die entsprechenden Schiebetakte A und B der einen oder der anderen Hauptverriegelungs-Schaltungsgruppe wirksam macht. Das heisst mit anderen Worten, dass dieses genannte Signal also im Zeitintervall des Verschiebens den fünf Hilfsverriegelungs-Schaltungen die eine oder die andere der beiden Gruppen zu je fünf Hauptverriegelungs-Schaltungen zuordnet. Eine solche Gruppe bildet somit zum Zeitpunkt des Verschiebens schaltungsmäsig zusammen mit den fünf Hilfsverriegelungs-Schaltungen SLT1 bis SLT5 eine Schiebekette, die dem prinzipiellen Aufbau einer bekannten Schiebekette, wie sie in Fig. 1 dargestellt ist, entspricht, da jeder Hauptverriegelungs-Schaltung eine Hilfsverriegelungs-Schaltung im Zeitintervall des Verschiebens schaltungsmässig zugeordnet ist. Zum Verschiebezeitintervall besitzt also jede Hauptvergelungs-Schaltung auch eine physikalisch vorhandene Hilfsverriegelungs-Schaltung und bildet somit vorübergehend eine Registerstufe wie sie in Fig. 1 dargestellt ist. Damit ist innerhalb eines solchen Schieberegisters eine Subkette gebildet, die nach den bekannten Schiebegesetzen arbeitet. Die andere Gruppe von HauptverriegelungsSchaltungen MLT bildet im erwähnten Zeitintervall im Gegensatz dazu eine Kette von virtuellen Speicherstufen, da die fünf HilfsverriegelungsSchaltungen in diesem Zeitintervall für diese Gruppe nicht physikalisch zur Verfügung stehen.

Wenn das Gruppensignal +SEL-Hauptgruppe die anderen fünf Hauptverriegelungs-Schaltungen, d.h. die andere Gruppe innerhalb der Verschiebekette selektiert, bildet die vorher selektierte Gruppe nunmehr die virtuellen Speicherstufen. Durch Einführung von mehreren Gruppensignalen, die auch codiert zugeführt werden können, und bei entsprechender Ausgestaltung der Hilfsverriegelungs-Schaltungen SLT mit mehreren Verschiebe-Dateneingängen, können die Hauptverriegelungs-Schaltungen MLT in mehr als zwei Gruppen aufgeteilt werden.

Die sich in diesem Falle ergebenden Schaltkreiseinsparungen sind vor allem bei hochintegrierten Chips signifikant. Dadurch wird nämlich nicht nur Siliciumfläche auf dem Chip eingespart, sondern es wird auch eine Verlustleistungsverringerung für eine bestimmte vorgegebene zu implementierende Funktion erreicht.

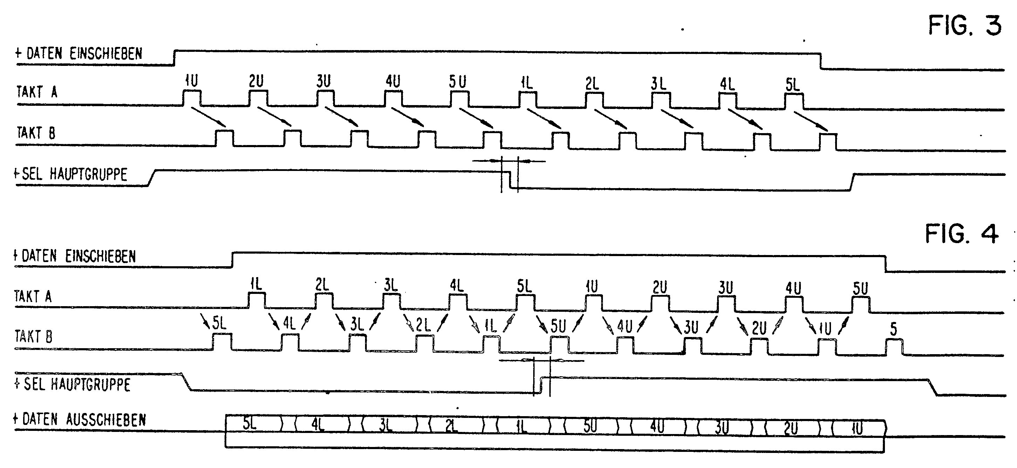

In Fig. 3 ist nun ein Zeitdiagramm für die Verschiebeoperation dargestellt, die mit Hilfe des in Fig. 2 dargestellten Schieberegisters ausgeführt werden kann. Zur Vereinfachung der Erklärung stellt das Zeitdiagramm nur die Schiebevorgänge, jedoch nicht das Setzen der Hauptverriegelungs-Schaltungen MLT im funktionellen logischen Betrieb dar.

In Fig. 3 ist zunächst das Einschieben von binären Einsen in alle zehn HauptverriegelungsSchaltungen MTL dargestellt. Zu diesem Zwecke wird das Signal Daten Einschieben auf der Leitung SDI des Schieberegisters nach Fig. 2 auf Eins gesetzt. Vor dem Verschieben wird ausserdem das Signal +SEL Hauptgruppe auf Eins gesetzt, um die obere Hauptverriegelungsgruppe U von fünf Hauptverriegelungs-Schaltungen MLT des Registers nach Fig. 2 zu selektieren und diese den fünf Hilfsverriegelungs-Schaltungen SLT zuzuordnen. Nach fünf Schiebetaktpaaren A/B ist die 1,1,1,1,1-Information in alle Hauptverriegelungs-Schaltungen der oberen Gruppe U hineingeschoben worden. Der fünfte Verschiebetakt B übernimmt lediglich noch alle Hauptverriegelungs-Schaltungen in ihre korrespondierenden Hilfsverriegelungs-Schaltungen, was bei der Einschiebeoperation auch als don't care-Funktion bezeichnet werden kann.

Danach wird das Signal +SEL-Hauptgruppe umgeschaltet und die Einschiebeoperation kann in gleicher Weise für die untere Gruppe L, bestehend aus den Hauptverriegelungs-Schaltungen MLT6 bis 10, durchgeführt werden.

In Fig. 4 ist das Datenausschieben aus den Hauptverriegelungs-Schaltungen beim gleichzeitigen Einschieben von Daten in die freigewordenen Hauptverriegelungs-Schaltungen dargestellt. Am Ausgang SDA des Schieberegisters nach Fig. 2 erscheinen dann die in den Hauptverriegelungs-Schaltungen gespeichert gewesenen binären Grössen in der dargestellten Reihenfolge, d.h. erst die der unteren Hauptverriegelungs-Schaltungsgruppe U.

Gleichzeitig werden durch den Eingang SDI des Schieberegisters nach Fig. 2 (in diesem Beispiel 1) in die freigewordenen Hauptverriegelungs-Schaltungen in umgekehrter Reihenfolge (jeweils in der gleichen Gruppe) Informationen gewissermassen nachgeschoben. Um jeweils eine Null nachzuschieben, muss die Leitung mit dem Signal SDI zu den jeweiligen Verschiebezeiten entsprechend gesteuert sein. Die jeweils zu schiebende Hauptverriegelungs-Schaltungsgruppe wird wiederum durch das Signal +SELHauptgruppe definiert und damit selektiert. Wenn die Schiebetakte A/B inaktiv sind (z.B. in einem logischen Funktionsbetrieb), wirkt sich auch das Signal +SEL-Hauptgruppe nicht aus und kann somit Eins oder Null sein. Zum besseren Verständnis der Verschiebeoperation sind in den Fig. 3 und 4 jeweils auf den Takten A und B die jeweilig angesteuerten Hauptverriegelungs-Schaltungen der einzelnen Gruppen angegeben, die sich mit der Bezeichnung in Fig. 2 decken.

Eine weitere Ausgestaltung des Erfindungsprinzips besteht in hochintegrierten Chips bei Makro-Stacks von logischen, physikalischen oder gar anwenderspezifischen Datenflussregisterverriegelungen einschliesslich der ihnen vorgeschalteten Multiplex-Eingangschalter. Ausserdem ist es ohne weiteres möglich, dass jeweils eine Hilfsverriegelungs-Schaltung Hauptverriegelungs-Schaltungen aus n Bytes, bestehend aus 9 Bits, zugeordnet wird, wenn das Verschieben von Daten byteweise erfolgt, wobei jeweils eine Hauptverriegelungs-Schaltungsgruppe durch jeweils ein Byte gebildet wird.

## Patentansprüche

1. Schieberegister für Prüf- und Test-Zwecke, das mit A- und B-Takten fortgeschaltet wird und dessen einzelne Stufen aus jeweils einer Hauptverriegelungs-Schaltung und einer Hilfsverriegelungs-Schaltung bestehen, das Bestandteil eines Logik- oder eines Speicher-Halbleiterchips in hochintegrierter Technik ist, dadurch gekennzeichnet, dass die in einem Schieberegister vorhandenen Hauptverriegelungs-Schaltungen (MLT1 bis MLT10) in Hauptgruppen durch Selektionssignale (+SEL-Hauptgruppe) auf einer entsprechenden Leitung selektiert werden, dass zum Zwecke des Ein-, Ver- oder Ausschiebens von Informationen jeweils zum Verschiebezeitpunkt die in Grösse einer Hauptgruppe vorhandenen Hilfsverriegelungs-Schaltungen (SLT1 bis 5) nacheinander den einzelnen Hauptgruppen von Hauptverriegelungs-Schaltungen (MLT) physikalisch zugeordnet werden, während gleichzeitig die nichtausgewählten Gruppen von Hauptverriegelungs-Schaltungen (MLT) eine Kette von virtuellen Speicherstufen bilden.

2. Schieberegister nach Anspruch 1, dadurch gekennzeichnet, dass die Verschiebetakte (A und B) den Hauptverriegelungs-Schaltkreisen (MLT) über bekannte logische Schaltungen (V) gruppenweise zugeführt werden, dass die Schiebedaten-Eingangsleitung (SDI) ebenfalls mit jeweils dem ersten Hauptverriegelungs-Schaltkreis (MLT1 bzw. MLT6) eine Gruppe verbunden ist, dass der Ausgang jeder Hauptverriegelungs-Schaltung (MLT1 bis MLT10) mit einer Randomlogik und mit einer der zugeordneten Hilfsverriegelungs-Schaltung (SLT1 bis SLT5) vorgeschalteten UND-Schaltung verbunden ist, deren anderer Eingang mit Takt- und Selektions-Signalen führenden Leitungen verbunden ist, und dass mit Ausnahme des Ausgangs einer der Hilfsverriegelungs-Schaltungen (SLT5) der Ausgang jeder Hilfsverriegelungs-Schaltung (SLT1 bis SLT4) mit den zugeordneten Hauptverriegelungs-Schaltungen (MLT) in jeder Gruppe des Registers verbunden ist.

3. Schieberegister nach Anspruch 2, dadurch gekennzeichnet, dass der Ausgang mindestens einer der Hilfsverriegelungs-Schaltungen (SLT5) als Schiebedatenausgang (SDA) des Schieberegisters ausgebildet ist.

4. Schieberegister nach den Ansprüchen 1 bis 3, dadurch gekennzeichnet, das beim byteweisen Verschieben von Daten innerhalb des Schieberegisters eine Hauptverriegelungs-Schaltungsgruppe durch jeweils die einem Byte entsprechende Anzahl von Hauptverriegelungs-Schaltungen (MLT) gebildet wird.

## Claims

1. Shift register for checking and testing purposes, which is shifted by means of A- and B-clocks, the individual stages of which consist of one main latch circuit and one auxiliary latch circuit, and which forms part of a logic or a semiconductor storage chip in highly integrated technology, characterized in that the main latch circuits (MLT1 to MLT10) present in a shift register are selected in main groups by selection signals (+SEL main group) on a corresponding line, that for the purpose of shifting in, shifting, or shifting out information at the respective shifting time, the auxiliary latch circuits (SLT1 to 5), matching the size of a main group, are successively physically associated with the individual main groups of main latch circuits (MLT), while the nonselected groups of main latch circuits (MLT) form a chain of virtual storage stages.

2. Shift register according to claim 1, characterized in that the shift clocks (A and B) are applied in groups to the main latch circuits (MLT) through known logic circuits (V), that the shift data input line (SDI) is also connected to the respective first main latch circuit (MLT1 and MLT6, respectively) of a group, that the output of each main latch circuit (MLT1 to MLT10) is connected to a random logic circuit means and to an AND circuit preceding the associated auxiliary latch circuit (SLT1 to SLT5) and whose other input is connected to lines carrying clock and selection signals, and that, with the exception of the output of one of the auxiliary latch circuits (SLT5), the output of each auxiliary latch circuit (SLT to SLT4) is connected to the associated main latch circuits (MLT) in each group of registers.

3. Shift register according to claim 2, characterized in that the output of at least one of the auxiliary latch circuits (SLT5) is designed as a shift data output (SDA) of the shift register.

4. Shift register according to any one of the claims 1 to 3, characterized in that during the byte-by-byte shifting of data in the shift register, a main latch circuit group is formed by a number of main latch circuits (MLT) corresponding to one byte.

## Revendications

1. Registre à décalage conçu pour des opérations de contrôle et de test, commandé par des signaux d'horloge A et B, dont chaque étage comporte une bascule de verrouillage principale et une bascule de verrouillage secondaire, et utilisé comme élément d'un circuit à semi-conducteurs de logique ou de mémoire de haute densité d'intégration, caractérisé en ce que les bascules de verrouillage principales (MLT1 à MLT10) dans un même registre à décalage sont sélectionnées par des signaux de sélection (groupe principal SEL) appliqués à une ligne correspondante pour former des groupes principaux, et en ce que, afin d'entrer des informations dans le registre, de les décaler à l'intérieur du registre et de les extraire du registre, lesdites bascules à verrouillage secondaires (SLT1 à SLT5) de la taille d'un groupe principal sont, lors de chaque décalage, disposées physiquement en aval des différents groupes principaux de bascules de verrouillage principales (MLT), tandis que les groupes non sélectionnés de bascules de verrouillage principales (MLT) constituent parallèlement une succession d'étages de mémoire virtuelle.

2. Registre à décalage selon la revendication 1, caractérisé en ce que des signaux de décalage (A et B) sont appliqués par groupes, à travers des circuits logiques connus (V), aux bascules de verrouillage principales (MLT), en ce que la ligne d'entrée des données de décalage (SDI) est également connectée à la première bascule de verrouillage principale (MLT1 à MLT6) de chaque groupe desdites bascules, en ce que la sortie de chaque bascule de verrouillage principale (MLT1 à MLT10) est connectée à un élément de logique aléatoire et à un circuit ET disposé en amont d'une desdites bascules de verrouillage secondaires (SLT1 à SLT5), les autres entrées dudit circuit ET étant connectées aux lignes acheminant les signaux de sélection et d'horloge, et en ce que, à l'exception de l'entrée d'une des bascules de verrouillage secondaires (SLT5), la sortie de chaque bascule de verrouillage secondaire (SLT1 à SLT4) est connectée auxdites bascules de verrouillage principales associées (MIT) de chaque groupe dudit registre à décalage.

3. Registre à décalage selon la revendication 2, caractérisé en ce que la sortie d'au moins une desdites bascules de verrouillage secondaires (SLT5) est conçue comme sortie des données de décalage (SDA) dudit registre à décalage.

4. Registre à décalage des données sous forme de multiplets à l'intérieur dudit registre à décalage, un groupe de bascules à verrouillage principales est constitué par le nombre de bascules de verrouillage principale (MLT) correspondant à un multiplet.

FIG. 1

FIG. 2

**FIG. 3**

+ DATEN EINSCHIEBEN

TAKT A

TAKT B

+ SEL HAUPTGRUPPE

**FIG. 4**

+ DATEN EINSCHIEBEN

TAKT A

TAKT B

+ SEL HAUPTGRUPPE

+ DATEN AUSSCHIEBEN

0 046 499